Europäisches Patentamt

European Patent Office

Office européen des brevets

(11) Numéro de publication : **0 421 532 B1**

(12) **FASCICULE DE BREVET EUROPEEN**

(45) Date de publication du fascicule du brevet :
**11.01.95 Bulletin 95/02**

(51) Int. Cl.[6] : **H04L 27/36,** H03F 1/32,
H04B 1/62

(21) Numéro de dépôt : **90202588.1**

(22) Date de dépôt : **01.10.90**

(54) **Dispositif de prédistorsion pour système de transmission numérique.**

(30) Priorité : **06.10.89 FR 8913093**

(43) Date de publication de la demande :
**10.04.91 Bulletin 91/15**

(45) Mention de la délivrance du brevet :
**11.01.95 Bulletin 95/02**

(84) Etats contractants désignés :
**DE FR GB SE**

(56) Documents cités :
**US-A- 4 291 277**
**AT & T BELL LABORATORIES TECHNICAL**
**JOURNAL. vol. 62, no. 4, avril 1983, NEW YORK**
**US pages 1019 - 1033; A. A. SALEH and J.**
**SALZ: "Adaptive Linearization or Power**
**Amplifiers in Digital Radio Systems"**

(73) Titulaire : **LABORATOIRES D'ELECTRONIQUE**
**PHILIPS**
**22, avenue Descartes,**
**BP 15**
**F-94453 Limeil-Brévannes Cédex (FR)**
(84) **FR**
Titulaire : **Philips Electronics N.V.**
**Groenewoudseweg 1**
**NL-5621 BA Eindhoven (NL)**
(84) **DE GB SE**

(72) Inventeur : **Karam, Georges, Société Civile**
**S.P.I.D.**
**156, Boulevard Haussmann**
**F-75008 Paris (FR)**
Inventeur : **Sari, Hikmet, Société Civile S.P.I.D.**
**156, Boulevard Haussmann**
**F-75008 Paris (FR)**

(74) Mandataire : **Landousy, Christian et al**
**Société Civile S.P.I.D.**
**156, Boulevard Haussmann**
**F-75008 Paris (FR)**

## Description

L'invention concerne un dispositif de prédistorsion pour système de transmission numérique qui transmet des données d'entrée complexes à la cadence d'une horloge symbole H de période T, à l'aide d'un modulateur et d'un amplificateur de puissance qui distord les données, le dispositif comprenant un circuit de prédistorsion qui prédistord en sens opposé les données d'entrée avant leur passage dans l'amplificateur afin de transmettre les données d'entrée attendues.

Un tel dispositif de prédistortion fait également l'objet de la demande de brevet EP-A-0 421 533 déposée le même jour.

L'invention trouve ses applications dans les systèmes de transmission numérique tels que les modems de transmission de données, les faisceaux hertziens, les systèmes de communications spatiales.

Pour une utilisation efficace du spectre disponible, les systèmes de transmission numérique actuels, notamment les faisceaux hertziens et les systèmes de transmission de données sur le canal téléphonique, utilisent des modulations à grands nombres d'états de phase et d'amplitude. Or ces modulations sont très sensibles à toute sorte de distorsion, et bien entendu, aux distorsions non linéaires provenant des amplificateurs, des mélangeurs et d'autres circuits non-linéaires de la chaîne de transmission. Un point particulièrement critique en faisceaux hertziens et en transmission par satellite est la non-linéarité de l'amplificateur de puissance d'émission ou de l'amplificateur de puissance embarqué dans le cas des transmissions par satellite. Ces amplificateurs sont connus pour leurs caractéristiques non-linéaires. Si on les utilise dans leur zone linéaire on ne bénéficie pas totalement de leur puissance. Si on les fait fonctionner proche de leur puissance de saturation, ils distordent le signal d'une façon inacceptable. En pratique, étant donné un amplificateur de puissance, on fixe le niveau du signal émis de façon à établir un compromis entre la rapport signal à bruit et la distorsion non-linéaire subie par le signal. Ainsi le point de fonctionnement optimal de l'amplificateur est celui minimisant les effets conjoints du bruit additif du canal et de la distorsion non-linéaire de l'amplificateur. Pour des modulations à grand nombre d'états (MAQ64 et MAQ256 par exemple), ce point est loin de la puissance de saturation de l'amplificateur, ce qui signifie que celui-ci n'est pas utilisé d'une façon efficace. Pour augmenter son efficacité, on utilise couramment des techniques de prédistorsion (fixe ou adaptative) qui permettent de réduire l'effet de la non-linéarité de l'amplificateur de puissance sur le signal émis.

Une technique de prédistorsion couramment utilisée consiste à placer à l'étage de fréquence intermédiaire de l'émetteur un circuit non-linéaire approchant la fonction inverse de l'amplificateur de puissance dont on vise à compenser les non-linéarités. Si l'on savait synthétiser l'inverse exact de la fonction de l'amplificateur, cette technique permettrait d'avoir un signal parfait en sortie (sans aucune distorsion non-linéaire). Toutefois, ceci n'est pas réalisable, car l'inverse exact nécessiterait un circuit de complexité infinie. En pratique, on se contente de faire une approximation et le plus souvent on limite à l'ordre 3 la série de Taylor représentant la fonction non-linéaire de l'amplificateur et on synthétise un circuit de prédistorsion, également d'ordre 3, tel que les deux circuits cascadés n'aient plus de distorsion d'ordre 3. Des termes d'ordres supérieurs (ordre 5 et ordre 7) apparaissent en sortie mais de faible amplitude comparés à la distorsion d'ordre 3 initiale. Il en résulte ainsi une certaine amélioration des performances du système. Un inconvénient de ces circuits de prédistorsion à l'étage de fréquence intermédiaire réside dans le fait que ce sont des circuits analogiques. Ils sont difficiles à rendre adaptatifs et nécessitent de temps à autre une intervention pour les réajuster et compenser les variations de la réponse de l'amplificateur avec le temps et avec la température. Cette technique de prédistorsion est en outre à exclure si l'on veut faire une commande automatique de puissance d'émission.

Une autre technique de prédistorsion, plus récente, consiste à modifier l'alphabet des données à émettre. Cette technique appelée "prédistorsion de données" ou "prédistorsion en bande de base" est connue du document US-A-4 291 277 et de l'article de A.A.M. SALEH et J. SALZ "Adaptive linearization of power amplifiers in digital radio systems" Bell System Technical Journal Vol. 62 Avril 1983, pages 1019-1033.

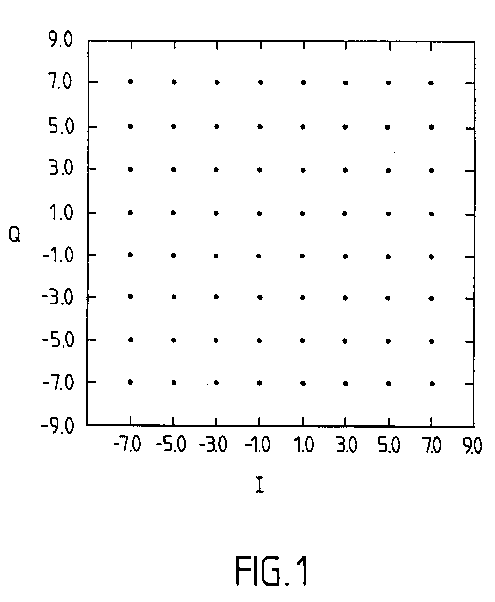

Dans l'article de A.A.M. SALEH et J. SALZ, la figure 1 est un schéma d'un circuit de prédistorsion adaptative qui fournit à l'entrée du modulateur une constellation distordue à partir de la constellation carrée d'origine, par exemple d'une modulation d'amplitude de deux porteuses en quadrature MAQ. L'amplificateur agit sur la constellation en produisant une nette compression et une nette rotation des points de grande amplitude. Pour compenser cet effet, la constellation d'origine est distordue de sorte qu'elle reprend sa forme carrée originelle après sont passage dans l'amplificateur de puissance. Ainsi, lorsque le circuit de prédistorsion est optimisé, il forme l'inverse de l'amplificateur de puissance (à un gain et à une phase près) et permet de compenser parfaitement les non-linéarités de l'amplificateur. Pour rendre ce circuit adaptatif, le signal est repris à la sortie de l'amplificateur, démodulé, puis échantillonné à la cadence d'émission des symboles 1/T et on compare ces échantillons au point correspondant de la constellation MAQ utilisée. Ces comparaisons permettent d'obtenir un signal de commande permettant d'optimiser le circuit de prédistorsion à l'aide d'un algorithme classique. Toutefois, le schéma utilisé sur cette figure 1 est très simpliste, car il ne dispose d'aucun filtrage avant le modulateur, ni avant l'amplificateur de puissance. Il ne correspond donc pas à la solution généralement utilisée. En effet dans les systèmes réels, on utilise toujours un filtrage de mise en forme spectrale de type Nyquist permettant de limiter la bande du signal tout en garantissant une interférence intersymbole nulle aux instants de décision. Ce filtrage est en général partagé équitablement entre l'émission et la réception pour maximiser le rapport signal à bruit également aux instants de décision. Dans de tels systèmes, l'effet de la non-linéarité de l'amplificateur est double : la constellation est non seulement déformée mais il apparaît une interférence intersymbole qui associe à chaque point de la constellation un nuage de points. Or, la technique de prédistorsion décrite ci-dessus ne permet pas de compenser ce deuxième effet.

Le problème posé est donc de réaliser un circuit de prédistorsion qui permette non seulement de corriger la constellation mais aussi de réduire considérablement la dispersion de chaque point de la constellation d'origine en un nuage de points et également d'assurer à la réception une protection élevée contre l'interférence des canaux adjacents.

Ce but doit être atteint en réduisant au maximum la complexité et la quantité de matériel nécessaire.

La solution à ce problème consiste en ce que le système comprend un filtre d'émission qui, à partir des données d'entrée, délivre, à la cadence k/T (où k est un entier supérieur à 1), des données filtrées suréchantillonnées au circuit de prédistorsion qui comprend des moyens pour déterminer tout d'abord des données prédistordues approchées $(F_{Io}, F_{Qo})$ à partir d'une partie 2 M bits des champs des 2 N bits (M<N), données qui sont ensuite révisées à l'aide de la partie restante des champs de 2 (N-M) bits pour fournir des données d'entrée prédistordues révisées $(\hat{F}_I, \hat{F}_Q)$.

Le filtre d'émission effectue une mise en forme spectrale qui est complétée par un filtrage de réception de telle sorte que le filtrage global émission-réception soit un filtre de Nyquist permettant ainsi de garantir une interférence intersymbole nulle aux instants de décision. Pour diminuer la taille des nuages de points il est nécessaire d'opérer une correction avec plus d'un échantillon par durée symbole T.

Ainsi avantageusement la détermination en cascade des données prédistordues approchées puis de celles révisées ne nécessite qu'un matériel réduit, comparé à une détermination à l'aide des champs complets de 2 N bits. Ceci est particulièrement sensible lorsque le circuit de prédistorsion utilise une mémoire. En opérant selon l'invention la taille de la mémoire est considérablement diminuée. Dans ce cas le circuit de prédistorsion comprend pour chaque voie un séparateur du champ de M bits et du champ de (N-M) bits, une mémoire adressée par le champ de 2 M bits qui délivre les données prédistordues approchées $(F_{Io}, F_{Qo})$, et un circuit d'interpolation qui en déduit les données prédistordues $(\hat{F}_I, \hat{F}_Q)$.

Pour déterminer les données prédistordues révisées $(\hat{F}_I, \hat{F}_Q)$, le circuit d'interpolation va utiliser les données prédistordues approchées $(F_{Io}, F_{Qo})$ auxquelles il va ajouter des valeurs qui dépendent du mécanisme de traitement mis en oeuvre par la séparation des champs de 2 M bits et des champs de 2 (N-M) bits. En particulier une manière simple d'effectuer cette séparation consiste à isoler pour chaque voie les M bits de poids forts des (N-M) bits de poids faibles. Dans ce cas le champ de M bits représente une valeur x et le champ de (N-M) bits représente une valeur $\Delta x$ (respectivement y et $\Delta y$ pour l'autre voie). Le circuit d'interpolation peut effectuer une approximation linéaire autour du point $(F_{Io}, F_{Qo})$. En particulier, en appelant $F_{Io}$, $F_{Qo}$ les données prédistordues approchées adressées par les valeurs d'adressage x et y, le circuit d'interpolation va pouvoir déterminer les données prédistordues révisées $\hat{F}_I$, $\hat{F}_Q$ selon :

$$\hat{F}_I = F_{Io} + (\partial F_I / \partial x).\Delta x + (\partial F_I / \partial y).\Delta y$$
$$\hat{F}_Q = F_{Qo} + (\partial F_Q / \partial x).\Delta x + (\partial F_Q / \partial y).\Delta y$$

où $\partial x$ et $\partial y$ sont des incréments prédéterminés imposés aux valeurs x et y correspondant respectivement aux champs de 2 M bits des voies I et Q. Ces relations sont déterminées en opérant en coordonnées cartésiennes. D'autres relations analogues peuvent être déterminées en opérant avec des coordonnées polaires.

Lorsque les données $F_{Io}$, $F_{Oo}$ sont stockées en mémoire il suffit d'effectuer des lectures successives de cette mémoire avec les couples d'adressage $(x+\partial x, y)$ et $(x, y+\partial y)$. On détermine ainsi par différence les dérivées partielles $\partial F_I / \partial x$, $\partial F_I / \partial y$, $\partial F_Q / \partial x$, $\partial F_Q / \partial y$.

Mais avantageusement pour accélérer le processus il est possible de dupliquer le chargement de la mémoire dans deux autres mémoires. L'une est adressée par le couple d'adressage $(x+\partial x, y)$ et l'autre par le couple d'adressage $(x, y+\partial y)$. Avantageusement les valeurs $\partial x$ et $\partial y$ correspondent à un écart de 1 bit de poids le plus faible du champ de bit d'adressage correspondant.

L'invention vient d'être décrite pour un système muni d'un circuit de prédistorsion fixe. Il existe en effet des situations où les mécanismes de distorsion sont relativement stables ou pour lesquelles une correction parfaite n'est pas recherchée. Mais généralement les mécanismes de distorsion sont évolutifs et il est alors nécessaire de les corriger en permanence. Dans ce cas le circuit de prédistorsion est adaptatif et pour cela comprend un circuit d'adaptation qui à partir d'une démodulation du flux de données transmises adapte continûment le circuit de prédistorsion à partir d'une comparaison des données d'entrée et des données transmises. L'écart observé sert à corriger les valeurs prédistordues ($F_{Io}$, $F_{Qo}$) qui sont stockées en mémoire et qui sont régulièrement mises à jour.

Le filtre d'émission placé à l'entrée du système et qui délivre plusieurs échantillons par durée symbole peut être constitué d'un filtre numérique. Il peut également être constitué d'un filtre analogique suivi d'un convertisseur analogique numérique qui délivre des échantillons aux mêmes cadences.

L'invention sera mieux comprise à l'aide des figures suivantes données à titre d'exemple non limitatifs et qui représentent :

figure 1 : la constellation d'une modulation MAQ64.

figure 2A : une constellation MAQ64 distordue par l'amplificateur de puissance dans un système sans filtrage ou dans le cas où tout le filtrage de Nyquist est effectué après l'étage de l'amplificateur.

figure 2B : une constellation prédistordue optimisée pour compenser la distorsion illustrée sur la figure 2A selon l'art antérieur.

figure 3A : la constellation distordue par l'amplificateur telle qu'elle apparaît lorsque le filtrage global est équitablement partagé entre l'émission et la réception et la partie à l'émission est placée avant l'amplificateur.

figure 3B : avec la même situation que celle de la figure 3A, mais en incorporant le circuit de prédistorsion de l'art antérieur.

figure 4 : un schéma d'un système de transmission numérique selon l'invention.

figure 5 : un schéma d'un circuit de prédistorsion selon l'invention.

figures 6A, 6B : un exemple de réalisation du circuit de prédistorsion.

figure 7 : un schéma d'un système de transmission numérique muni d'un circuit de prédistorsion adaptatif selon l'invention.

La figure 1 est un rappel de la représentation de la constellation d'un signal de type MAQ64. Les entrées I (en phase) et Q (en quadrature) du modulateur sont indépendantes et les symboles sur chaque voie prennent leurs valeurs dans un alphabet (±d, ±3d, ±5d, ±7d).

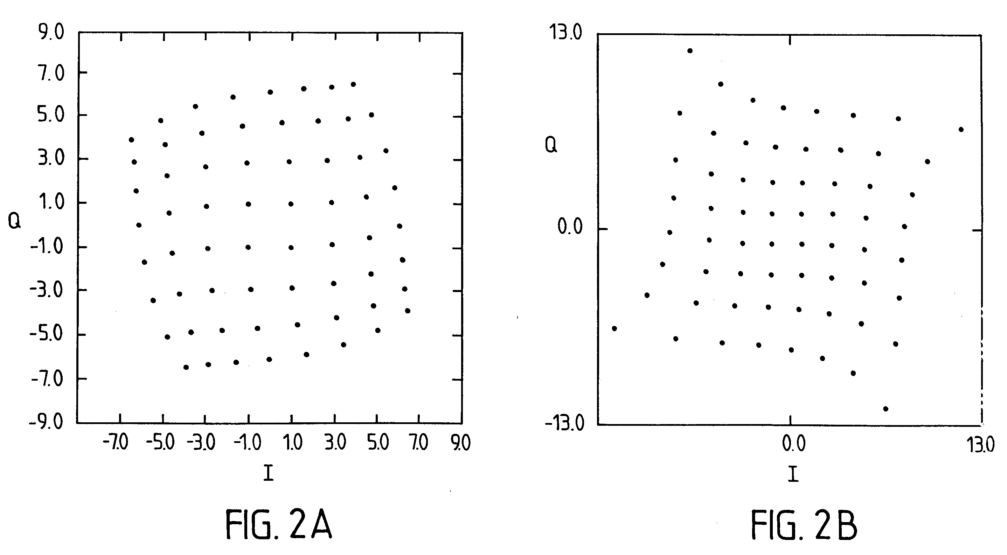

Pour être transmis le signal issu du modulateur est introduit dans un amplificateur de puissance qui est généralement utilisé à puissance réduite, c'est-à-dire dans une partie linéaire de sa caractéristique. A forte puissance cet amplificateur est non-linéaire et distord le signal de manière inacceptable. Si l'on observe une constellation de type MAQ64 à la sortie d'un tel amplificateur opérant proche de la saturation, on observe une constellation distordue comme celle représentée sur la figure 2A. Selon l'art antérieur il suffit alors de prédistordre dans le sens opposé la constellation selon le schéma de la figure 2B pour que en sortie de l'amplificateur on obtienne la constellation d'origine non déformée. Or une situation aussi simple n'est pas conforme à la réalité où il existe toujours un filtrage avant l'amplificateur de puissance notamment pour limiter la bande du signal. En absence de filtrage, le signal à l'entrée du modulateur varie par paliers une fois par durée symbole T. Ainsi, un circuit de prédistorsion agissant sur le signal à cadence 1/T permet une compensation parfaite. Par contre, lorsque le signal est filtré, il ne varie plus par paliers mais d'une façon continue. Pour une compensation parfaite de l'effet de la non-linéarité, il ne suffit plus d'observer le signal une fois par durée symbole T et de compenser la distorsion à ces moments là.

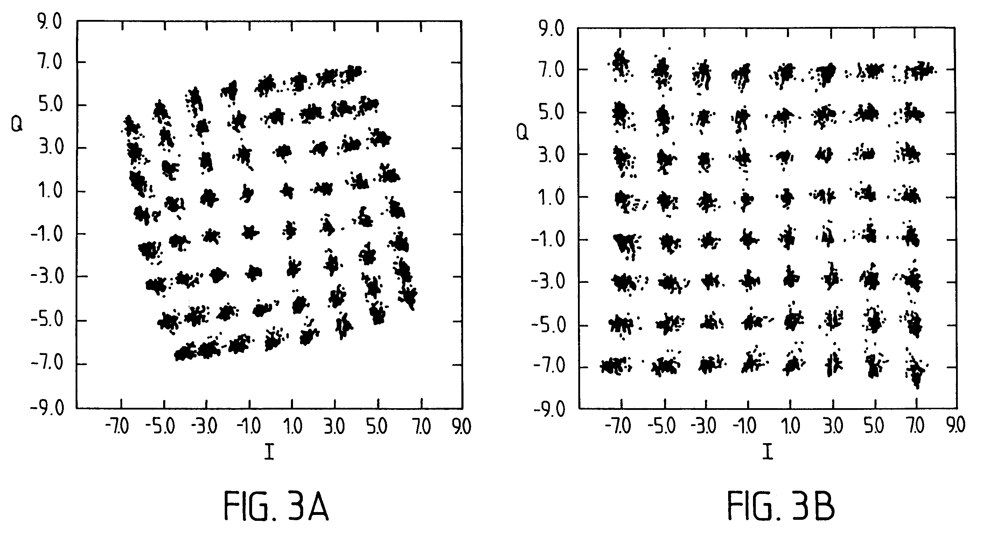

En présence d'un signal filtré la constellation à la sortie de l'amplificateur est représentée sur la figure 3A. Elle devient telle que représentée sur la figure 3B avec le circuit de prédistorsion de l'art antérieur. Ainsi chaque point de la constellation devient un nuage de points ce qui est inacceptable. Pour opérer avec un signal filtré il faut donc opérer la correction à plus d'un point par durée symbole. Pour cela on réalise la mise en forme spectrale d'émission par un filtre numérique délivrant à sa sortie les données filtrées à la cadence k/T ($k \geq 2$). Dans le cas où cette mise en forme est réalisée par un filtre analogique, on échantillonne le signal sortant du filtre à la cadence k/T. On dispose ainsi tous les T/k des échantillons du signal filtré que l'on peut prédistordre.

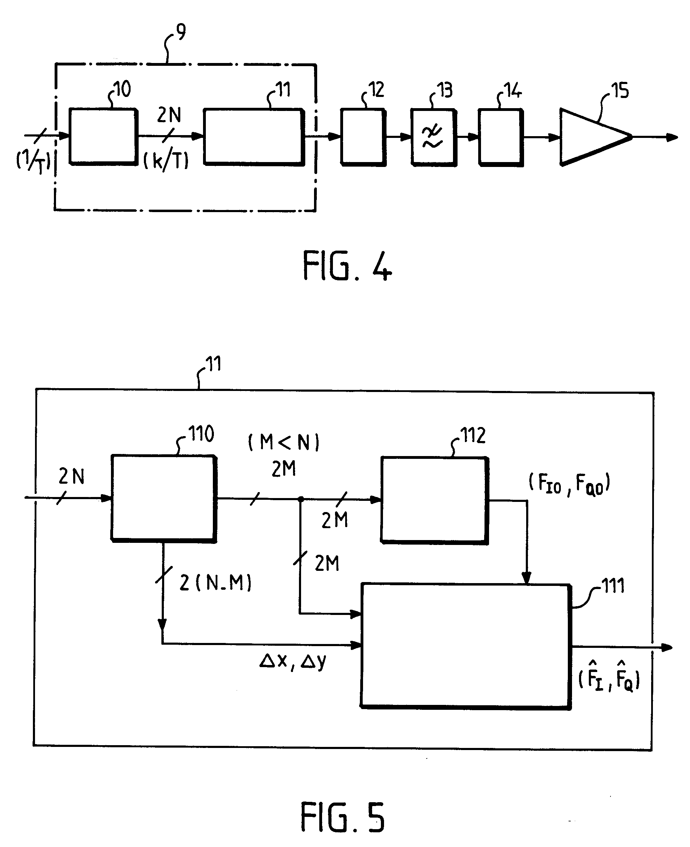

La figure 4 représente un système de transmission numérique avec un dispositif de prédistorsion 9 muni d'un filtre d'émission 10 qui délivre des échantillons, codés sur N bits, à la cadence k/T (k entier au moins égal à 2), et d'un circuit de prédistorsion 11 suivi d'un convertisseur numérique-analogique 12, d'un filtre analogique 13, d'un modulateur 14 et de l'amplificateur 15. C'est cet amplificateur qui distord les données qu'il a à transmettre à l'antenne d'émission.

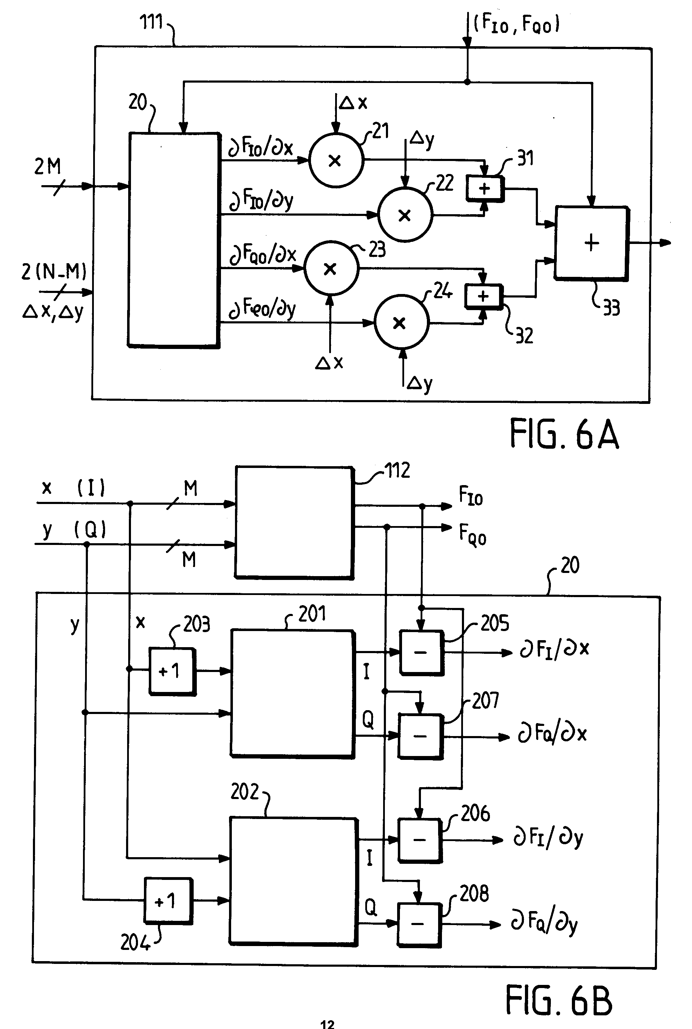

La figure 5 représente un exemple d'un schéma du circuit de prédistorsion 11. Il comprend un séparateur 110 qui reçoit les données complexes codées sur 2 N bits (voies I et Q) et qui sépare pour chaque voie un champ de M bits de poids forts et un champ restant de (N-M) bits de poids faibles (M<N). Les champs de 2 M bits adressent une mémoire 112 qui stocke des valeurs prédistordues approchées ($F_{Io}$, $F_{Qo}$). Les champs de 2 (N-M) bits entrent dans un circuit d'interpolation 111. Les deux champs de (N-M) bits représentent respectivement une valeur $\Delta x$ et $\Delta y$ pour chaque voie. Les deux champs de M bits représentent respectivement une valeur x et y pour chaque voie. A partir des données approchées $F_{Io}$, $F_{Qo}$ et de leurs champs d'adressage, le circuit d'interpolation 111 va calculer, à l'aide des valeurs $\Delta x$, $\Delta y$, les données révisées ($\hat{F}_I$, $\hat{F}_Q$). Un exemple de réalisation, représenté sur les figures 6A et 6B, opère les calculs en coordonnées cartésiennes selon :

$$\hat{F}_I = F_{Io} + (\partial F_I/\partial x).\Delta x + (\partial F_I/\partial y).\Delta y$$
$$\hat{F}_Q = F_{Qo} + (\partial F_Q/\partial x).\Delta x + (\partial F_Q/\partial y).\Delta y$$

Pour cela, pour chaque valeur approchée $F_{Io}$,

$F_{Qo}$, un circuit 20 de calcul de dérivées partielles calcule les dérivées partielles en appliquant des incréments $\partial x$, $\partial y$ aux valeurs associées aux champs d'adressage. Ces dérivées partielles et les valeurs $\Delta x$, $\Delta y$ servent à déterminer $\hat{F}_I$, $\hat{F}_Q$ selon les équations précédentes à l'aide des multiplieurs 21, 22, 23, 24 et des additionneurs 31, 32, 33.

Le circuit 20 peut contenir la mémoire 112. Dans ce cas cette mémoire est lue plusieurs fois successivement pour opérer selon le mécanisme décrit ci-après. Mais préférentiellement on utilise trois mémoires afin d'opérer un traitement en parallèle selon le schéma de la figure 6B. Deux mémoires 201, 202 stockent les mêmes données que la mémoire 112. La mémoire 201 est adressée par le champ Q de M bits et par le champ I de M bits (valeur x) qui est incrémenté de 1 bit dans l'additionneur 203. Cette valeur de 1 bit (incrément $\partial x$) permet de calculer les dérivées partielles $\partial F_I/\partial x$, $\partial F_Q/\partial x$ par simple différence dans les soustracteurs 205 et 207 pour les voies I et Q.

De même la mémoire 202 est adressée par le champ I de M bits et par le champ Q de M bits (valeur y) qui est incrémenté de 1 bit dans l'additionneur 204. Cette valeur de 1 bit (incrément $\partial y$) permet de calculer les dérivées partielles $\partial F_I/\partial y$ et $\partial F_Q/\partial y$ par simple différence dans les soustracteurs 206 et 208 pour les voies I et Q.

Ainsi en adressant la mémoire 112 par un champ de M bits au lieu d'un champ de N bits on réduit considérablement sa taille qui serait de $2^{2M}$ mots. Dans les applications utilisant des modulations MAQ64 et MAQ256, N est généralement de l'ordre de 10 bits. En passant de N=10 bits à M=4 ou 5 bits on réduit la taille de la mémoire à environ 1Kmots au lieu de 1Mmots ce qui est considérable, tout en gardant une bonne compensation des distorsions de l'amplificateur.

Le filtre d'émission 10 (figure 4) doit délivrer les échantillons complexes codés sur N bits à la cadence k/T avec k au moins égal à 2. Ce filtre d'émission peut être un filtre numérique. Il peut également être constitué d'un filtre analogique suivi d'une conversion analogique-numérique.

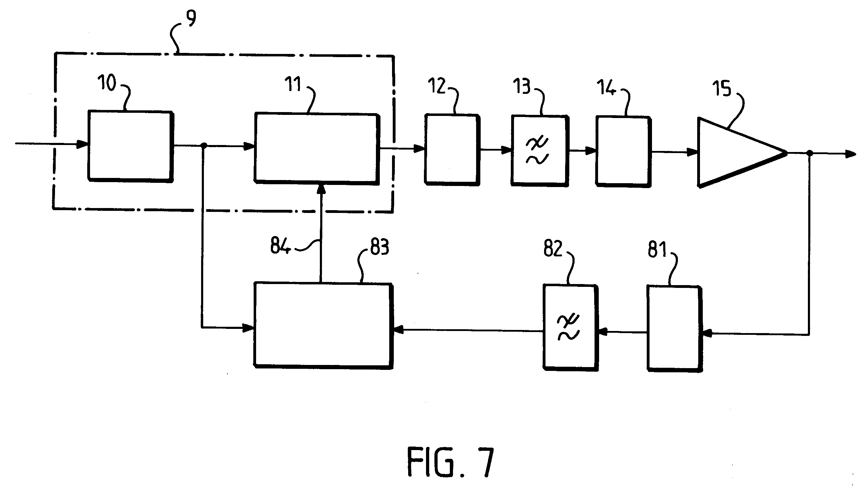

Le schéma de la figure 4 représente un système de transmission qui permet de prédistordre les données et de corriger les distorsions apportées par l'amplificateur dans le cas d'une structure fixe. Mais il est également possible de réaliser une structure adaptative. Ceci est représenté sur le schéma de la figure 7. Les mêmes éléments que ceux de la figure 4 sont représentés avec les mêmes repères. Dans ce cas on prélève le signal de sortie de l'amplificateur 15 pour l'introduire dans un démodulateur 81 suivi d'un filtre passe-bas 82 dont la sortie entre dans un circuit d'adaptation 83. Celui-ci échantillonne le signal de sortie du filtre 82 et compare ces données aux données d'entrée. L'écart donne naissance à un signal d'erreur qui permet (connexion 84) de mettre à jour le circuit de prédistorsion 11 par exemple en stockant de nouvelles valeurs $F_{Io}$, $F_{Qo}$ dans la mémoire.

**Revendications**

1. Dispositif de prédistorsion (9) pour système de transmission numérique qui transmet des données d'entrée complexes d'une constellation à la cadence d'une horloge symbole H de période T, à l'aide d'un modulateur (14) et d'un amplificateur de puissance (15) qui distord les données, le dispositif comprenant un circuit de prédistorsion (11) qui prédistord en sens opposé les données d'entrée avant leur passage dans l'amplificateur afin de transmettre les données d'entrée attendues, caractérisé en ce qu'il comprend un filtre d'émission (10) qui, à partir des données d'entrée, délivre, à la cadence k/T (où k est un entier supérieur à 1), des données filtrées suréchantillonnées codées sur 2 N bits au circuit de prédistorsion qui comprend des moyens (110, 111, 112) pour déterminer tout d'abord des données prédistordues approchées ($F_{Io}$,$F_{Qo}$) à partir d'une partie 2 M bits du champ des 2 N bits (M<N), pour réviser ces données à l'aide de la partie restante des champs de 2 (N-M) bits et pour fournir des données d'entrée prédistordues révisées ($\hat{F}_I$,$\hat{F}_Q$).

2. Dispositif selon la revendication 1 caractérisé en ce que le circuit de prédistorsion comprend pour chaque voie un séparateur (110) du champ de M bits et du champ de (N-M) bits, une mémoire (112) adressée par le champ de M bits qui délivre les données prédistordues approchées ($F_{Io}$,$F_{Qo}$), et un circuit d'interpolation (111) qui en déduit les données prédistordues révisées ($\hat{F}_I$,$\hat{F}_Q$).

3. Dispositif selon la revendication 2 caractérisé en ce que le circuit d'interpolation (111) effectue une approximation linéaire autour des points ($F_{Io}$,$F_{Qo}$).

4. Dispositif selon la revendication 3 caractérisé en ce que le séparateur (110) isole les champs de M bits de poids forts, le circuit d'interpolation (111) déterminant les données $\hat{F}_I$, $\hat{F}_Q$ selon :

$$\hat{F}_I = F_{Io} + (\partial F_I/\partial x).\Delta x + (\partial F_I/\partial y).\Delta y$$
$$\hat{F}_Q = F_{Qo} + (\partial F_Q/\partial x).\Delta x + (\partial F_Q/\partial y).\Delta y$$

où $\Delta x$ et $\Delta y$ représentent respectivement les valeurs correspondant aux champs de (N-M) bits sur les voies I (en phase) et Q (en quadrature), et $\partial x$ et $\partial y$ sont des incréments prédéterminés imposés aux valeurs x et y correspondant respectivement aux champs de M bits sur les voies I et Q, permettant le calcul des dérivées partielles sur les voies I et Q.

5. Dispositif selon la revendication 4 caractérisé en ce que les valeurs $\partial F_I/\partial x$, et $\partial F_Q/\partial x$ d'une part et $\partial F_I/\partial y$ et $\partial F_Q/\partial y$ d'autre part sont obtenues en adressant la mémoire (112) successivement par les valeurs $[(x+\partial x);y]$ et $[x;(y+\partial y)]$.

6. Dispositif selon la revendication 5 caractérisé en ce que le chargement de la mémoire (112) est dupliqué dans deux autres mémoires pour permettre un calcul en parallèle des dérivées partielles.

7. Dispositif selon une des revendications 4 à 6 caractérisé en ce que les valeurs de $\partial x$ et $\partial y$ correspondent à un écart de 1 bit de poids le plus faible du champ de bits d'adressage correspondant.

8. Dispositif selon une des revendications 1 à 7 caractérisé en ce que le filtre d'émission (10) est soit un filtre numérique soit un filtre analogique suivi d'un convertisseur analogique/numérique.

9. Dispositif selon une des revendications 1 à 8 caractérisé en ce que le circuit de prédistorsion (11) est adaptatif et pour cela comprend un circuit d'adaptation (83) qui à partir d'une démodulation du flux de données transmises adapte continûment le circuit de prédistorsion (11) à partir d'une comparaison des données d'entrée et des données transmises.

## Patentansprüche

1. Vorverzerrungseinrichtung (9) für ein digitales Übertragungssystem, das komplexe Eingangsdaten einer Konfiguration im Zyklus eines Zeichentaktgebers H der Periode T mittels eines Modulators (14) und eines Leistungsverstärkers (15), der die Daten verzerrt, überträgt, wobei die Einrichtung eine Vorverzerrungsschaltung (11) umfaßt, die die Eingangsdaten in entgegengesetzter Richtung vor ihrem Eintritt in den Verstärker vorverzerrt, um die erwarteten Eingangsdaten zu übertragen, dadurch gekennzeichnet, daß sie einen Sendefilter (10) umfaßt, der aus den Eingangsdaten im Takt k/T (mit k = ganzzahlig größer 1) gefilterte, überabgetastete, auf 2 N Bits codierte Daten an die Vorverzerrungsschaltung (11) ausgibt, die Mittel (110, 111, 112) umfaßt, um zuerst vorverzerrte Näherungswerte ($F_{Io}$, $F_{Qo}$) aus einem 2 M Bit-Teil des 2 N Bit-Felds (M < N) zu bestimmen, um diese Daten mit Hilfe des übrigen Teils des 2 (N-M) Bit-Felds zu korrigieren und um korrigierte vorverzerrte Eingangsdaten ($F_I$, $F_Q$) auszugeben.

2. Einrichtung nach Anspruch 1, dadurch gekennzeichnet, daß die Vorverzerrungsschaltung für jede Strecke eine Einrichtung (110) zum Auftrennen des M Bit-Felds und des (N-M) Bit-Felds, einen vom M Bit-Feld adressierten Speicher (112), der vorverzerrte Näherungswerte ($F_{Io}$, $F_{Qo}$) ausgibt, und eine Interpolationsschaltung (111), die daraus die vorverzerrten korrigierten Daten ($F_I$, $F_Q$) ableitet, umfaßt.

3. Einrichtung nach Anspruch 2, dadurch gekennzeichnet, daß die Interpolationsschaltung (111) eine lineare Näherung an die Punkte ($F_{Io}$, $F_{Qo}$) durchführt.

4. Einrichtung nach Anspruch 3, dadurch gekennzeichnet, daß die Einrichtung zum Auftrennen (110) die Felder der höherwertigen M Bits abtrennt, wobei die Interpolationsschaltung (111) die Daten $\hat{F}_I$, $\hat{F}_Q$ nach folgender Gleichung bestimmt:
$$\hat{F}_I = F_{Io} + (\partial F_I/\partial x)\cdot\Delta x + (\partial F_I/\partial y)\cdot\Delta y$$
$$\hat{F}_Q = F_{Qo} + (\partial F_Q/\partial x)\cdot\Delta x + (\partial F_Q/\partial y)\cdot\Delta y$$
worin $\partial x$ und $\partial y$ die den (N-M) Bit-Feldern auf den Strecken I (gleichphasig) bzw. Q (um 90° phasenverschoben) entsprechenden Werte darstellen und $\partial x$ und $\partial y$ vorherbestimmte Inkremente sind, die den jeweils den M Bit-Feldern der Strecken I und Q entsprechenden Werten x und y zugeordnet werden, womit partielle Ableitungen der Strecken I und Q berechnet werden können.

5. Einrichtung nach Anspruch 4, dadurch gekennzeichnet, daß man die Werte $\partial F_I/\partial x$ und $\partial F_Q/\partial x$ einerseits und $\partial F_I/\partial y$ und $\partial F_Q/\partial y$ andererseits erhält, indem der Speicher (112) nacheinander durch die Werte $[(x+\partial x);y]$ und $[x;(y+\partial y)]$ adressiert wird.

6. Einrichtung nach Anspruch 5, dadurch gekennzeichnet, daß der Inhalt des Speichers (112) in zwei andere Speicher dupliziert wird, um eine Parallelberechnung der partiellen Ableitungen zu ermöglichen.

7. Einrichtung nach einem der Ansprüche 4 bis 6, dadurch gekennzeichnet, daß die Werte von $\partial x$ und $\partial y$ einem Abstand von 1 niederwertigeren Bit des entsprechenden Adreßbitfelds entsprechen.

8. Einrichtung nach einem der Ansprüche 1 bis 7, dadurch gekennzeichnet, daß der Sendefilter (10) entweder ein digitaler oder ein analoger Filter mit nachgeschaltetem Analog-Digital-Umsetzer ist.

9. Einrichtung nach einem der Ansprüche 1 bis 8, dadurch gekennzeichnet, daß die Vorverzerrungsschaltung (11) adaptiv ist und hierzu eine Anpassungsschaltung (83) umfaßt, die anhand einer Demodulation des übertragenen Datenstroms die Vorverzerrungsschaltung (11) anhand eines Vergleichs der Eingangsdaten und der übertragenen Daten kontinuierlich anpaßt.

## Claims

1. Predistortion arrangement (9) for a digital transmission system which transmits complex input data at the rate defined by a symbol clock H having a period T, with the aid of a modulator (14) and a power amplifier (15) which distorts the data, the arrangement comprising a predistortion circuit (11) predistorting in a sense opposite to the input data before they pass through the amplifier in order to transmit the expected input data, characterized in that the arrangement comprises a transmit filter (10) which applies filtered, oversampled data encoded with 2N bits to the predistortion circuit at the rate k/T (where k is an integer greater than 1) in response to the input data, which circuit includes means (110, 111, 112) for first determining approximate predistorted data $(F_{Io}, F_{Qo})$ on the basis of a portion of 2M bits of the field of 2N bits (M < N), to revise these data with the aid of the remaining portion of the field of 2(N-M) bits and to produce revised predistorted input data $(\hat{F}_I, \hat{F}Q)$ .

2. Arrangement as claimed in Claim 1, characterized in that the predistortion circuit comprises for each channel a separator (110) for the field of M bits and the field of (N-M) bits, a memory (112) addressed by the field of M bits which produces the approximate predistorted data $(F_{Io}, F_{Qo})$, and an interpolation circuit (111) which derives therefrom the revised predistorted data $(\hat{F}_I, \hat{F}Q)$.

3. Arrangement as claimed in Claim 2, characterized in that the interpolation circuit (111) performs a linear approximation around the points $(F_{Io}, F_{Qo})$.

4. Arrangement as claimed in Claim 3, characterized in that the separator (110) isolates the fields of M most significant bits while the interpolation circuit (111) determines the data FI, FQ according to:
$$\hat{F}_I = F_{Io} + (\partial FI/\partial x).\Delta x + (\partial F_I/\partial y).\Delta y$$
$$\hat{F}_Q = F_{Qo} + (\partial FQ/\partial x).\Delta x + (\partial F_Q/\partial y).\Delta y$$
where $\Delta x$ and $\Delta y$ represent the values corresponding to the fields of (N - M) bits on the channels I (in-phase) and Q (quadrature) respectively, and $\partial x$ and $\partial y$ are predetermined increments imposed on the values x and y corresponding to the fields of M bits of the channels I and Q respectively, which makes it possible to calculate partial derivations of the channels I and Q.

5. Arrangement as claimed in Claim 4, characterized in that the values $\partial F_I/\partial x$ and $\partial F_Q/\partial x$, on the one hand, and $\partial F_I/\partial y$ $\partial F_Q/\partial y$, on the other, are obtained by successively addressing the memory (112) by the values $[(x+\partial x);y]$ and $[x;(y+\partial y)]$.

6. Arrangement as claimed in Claim 5, characterized in that the loading of the memory (112) is duplicated in two further memories for making a parallel calculation possible of the partial derivations.

7. Arrangement as claimed in one of the Claims 4 to 6, characterized in that the values $\partial x$ and $\partial y$ correspond to a difference of 1 least significant bit of the corresponding address bit field.

8. Arrangement as claimed in one of the Claims 1 to 7, characterized in that the transmit filter (10) is either a digital filter or an analog filter whose output is connected to an analog-to-digital converter.

9. Arrangement as claimed in one of the Claims 1 to 8, characterized in that the predistortion circuit (11) is adaptive and therefore comprises an adaptation circuit (83) which continuously adapts the predistortion circuit (11) in response to a comparison of the input data and the transmitted data, by means of a demodulation of the transmitted data stream.

FIG.1

FIG. 2A

FIG. 2B

EP 0 421 532 B1

FIG. 3A

FIG. 3B

FIG. 4

FIG. 5

FIG. 6A

FIG. 6B

FIG. 7